# EUROPÄISCHE PATENTANMELDUNG

(11) **EP 3 639 962 A1**
(43) Veröffentlichungstag der Anmeldung: **22.04.2020**
(21) Anmeldenummer: 19193516.2
(22) Anmeldetag: 26.08.2019
(51) Int. Cl.: B23K 11/11, B23K 11/25, B23K 31/12

(54) **VERFAHREN ZUM ÜBERPRÜFEN DER QUALITÄT BEIM WIDERSTANDSSCHWEISSEN VON WERKSTÜCKEN**

(30) Priorität: 11.10.2018 DE 102018217364
(71) Anmelder: Robert Bosch GmbH, 70442 Stuttgart (DE)
(72) Erfinder: Haeufgloeckner, Juergen, 63936 Schneeberg (DE); Stolze, Josephine, 69412 Eberbach (DE)

(57) **Zusammenfassung**

Die Erfindung betrifft ein Verfahren zum Überprüfen der Qualität bei einem Widerstandsschweißen von Werkstücken (121, 122), wobei Schweißelektroden (111, 112) mit Hilfe eines Elektrodenantriebs (130) mit einer Elektrodenkraft gegen einen Schweißpunkt (125) der Werkstücke (121, 122) gepresst werden und wobei im Zuge eines Schweißprozesses die Schweißelektroden (111, 112) für die Dauer einer Schweißzeit mit einem Schweißstrom bestromt werden, um eine Oberfläche der Werkstücke (121, 122) zu verflüssigen, wobei zu einem ersten Zeitpunkt vor einem Beginn des Verflüssigens ein erster Wert eines eine Lage einer oder beider Elektroden kennzeichnenden Schweißelektrodenparameters bestimmt wird, wobei zu dem ersten Zeitpunkt die Schweißelektroden (111, 112) mit der Elektrodenkraft gegen den Schweißpunkt (125) der Werkstücke (121, 122) gepresst werden, wobei zu einem zweiten Zeitpunkt nach einem Beginn des Verflüssigens ein zweiter Wert des eine Lage einer oder beider Elektroden kennzeichnenden Schweißelektrodenparameters bestimmt wird, wobei zu dem zweiten Zeitpunkt die Schweißelektroden (111, 112) mit der Elektrodenkraft gegen den Schweißpunkt (125) der Werkstücke (121, 122) gepresst werden, wobei der erste Wert und der zweite Wert miteinander verglichen werden und in Abhängigkeit von einem Vergleichsergebnis eine Qualität des Schweißprozesses beurteilt wird.

## Beschreibung

### Beschreibung

Die vorliegende Erfindung betrifft ein Verfahren zum Überprüfen der Qualität bei einem Widerstandsschweißen von Werkstücken sowie eine Steuereinheit, ein Schweißgerät und ein Computerprogramm zu dessen Durchführung.

### Stand der Technik

Mittels Schweißprozessen wie beispielsweise dem Widerstandsschweißen können Werkstücke stoffschlüssig miteinander verbunden werden. Beispielsweise werden im Zuge des automatisierten Karosserierohbaus durch robotergeführte Schweißzangen unterschiedliche Werkstücke, z.B. Bleche, mittels Widerstandsschweißen miteinander verschweißt.

Im Zuge des Widerstandsschweißens werden zunächst im Zuge einer sog. Kraftaufbauphase zwei Schweißelektroden einer Schweißzange mit Hilfe eines Elektrodenantriebs gegen einen Schweißpunkt der Werkstücke gepresst bis eine vorgegebene Elektrodenkraft erreicht ist. Anschließend erfolgt der eigentliche Schweißprozess, im Zuge dessen die Schweißelektroden für die Dauer einer Schweißzeit mit einem Schweißstrom bestromt werden, wodurch eine Widerstandserwärmung der beiden zu verschweißenden Werkstücke zwischen den Schweißelektroden erfolgt und die Werkstücke bis zum Erreichen einer erforderlichen Schweißtemperatur erhitzt werden.

### Offenbarung der Erfindung

Vor diesem Hintergrund werden ein Verfahren zum Überprüfen der Qualität bei einem Widerstandsschweißen von Werkstücken sowie eine Steuereinheit, ein Schweißgerät und ein Computerprogramm zu dessen Durchführung mit den Merkmalen der unabhängigen Patentansprüche vorgeschlagen. Vorteilhafte Ausgestaltungen sind Gegenstand der Unteransprüche sowie der nachfolgenden Beschreibung.

Schweißelektroden werden mit Hilfe eines Elektrodenantriebs mit einer Elektrodenkraft gegen einen Schweißpunkt der Werkstücke gepresst und im Zuge eines Schweißprozesses werden die Schweißelektroden mit einem Schweißstrom bestromt, um eine Oberfläche der Werkstücke zu verflüssigen bzw. aufzuschmelzen. Insbesondere wird die Schweißstromstärke zu Beginn des Schweißprozesses im Zuge einer sog. Stromaufbauphase bis zu einem vorgegebenen Wert erhöht. Am Ende des Schweißprozesses wird die Schweißstromstärke im Zuge einer sog. Stromabbauphase zweckmäßigerweise bis auf den Wert Null verringert.

Im Rahmen des vorliegenden Verfahrens wird zu einem ersten Zeitpunkt ein erster Wert eines eine Lage einer oder beider Elektroden kennzeichnenden Schweißelektrodenparameters bestimmt. Zu diesem ersten Zeitpunkt werden die Schweißelektroden vor einem Beginn des Verflüssigens mit der Elektrodenkraft gegen den Schweißpunkt der Werkstücke gepresst. Zu einem zweiten Zeitpunkt nach einem Beginn des Verflüssigens wird ein zweiter Wert des Schweißelektrodenparameters bestimmt, wobei zu diesem zweiten Zeitpunkt die Schweißelektroden mit der Elektrodenkraft gegen den Schweißpunkt der Werkstücke gepresst werden.

Der erste Zeitpunkt ist insbesondere ein Zeitpunkt vor einem Beginn oder während der ersten Phasen des Schweißprozesses, zu welchem die Werkstoffoberflächen jedoch noch nicht verflüssigt bzw. aufgeschmolzen sind. Entweder fließt zu dem ersten Zeitpunkt noch kein Schweißstrom oder es fließt zwar bereits ein Schweißstrom, der aber noch derart gering ist, dass noch kein Verflüssigen der Werkstückoberflächen erfolgt.

Der zweite Zeitpunkt ist insbesondere ein Zeitpunkt während der letzten Phasen oder nach dem Ende des Schweißprozesses. Insbesondere können die Werkstückoberflächen zu dem zweiten Zeitpunkt bereits wieder verfestigt sein. Entweder fließt zu dem zweiten Zeitpunkt kein Schweißstrom mehr oder es fließt zwar noch ein Schweißstrom, jedoch ist dieser zu gering, um noch ein weiteres Verflüssigen zu ermöglichen. Insbesondere liegt somit der zweite Zeitpunkt nach einem Ende des Verflüssigens, d.h. es findet kein weiterer Phasenübergang fest nach flüssig statt, weiter insbesondere nach Beginn des Verfestigens, d.h. es findet bereits ein Phasenübergang flüssig nach fest statt, noch weiter insbesondere nach Ende des Verfestigens, d.h. die Werkstückoberflächen sind bereits wieder fest.

Der erste Wert und der zweite Wert werden miteinander verglichen und in Abhängigkeit von einem Vergleichsergebnis wird eine Qualität des Schweißprozesses beurteilt. Im Rahmen der vorliegenden Erfindung wurde erkannt, dass der Schweißelektrodenparameter und insbesondere dessen erster und zweiter Wert vor bzw. nach dem Beginn des Verflüssigens eine besonders effektive Möglichkeit darstellen, um die Qualität des Schweißprozesses beurteilen und ferner quantifizieren zu können.

Der eine Lage einer oder beider Elektroden kennzeichnende Schweißelektrodenparameter charakterisiert eine Position bzw. Lage der Schweißelektroden. Beispielsweise kann der Lageistwert dabei relativ zu dem Schweißpunkt bzw. den Werkstücken bestimmt werden oder zweckmäßigerweise auch in Relation zu einem Referenzpunkt des Schweißgeräts, insbesondere zu einer Ruhelage der Schweißelektroden. Insbesondere charakterisiert die Lage bzw. der Lageistwert die Position der Elektrodenkappen im Raum. Ferner wird insbesondere nur eine Achse betrachtet, zweckmäßigerweise eine Achse in Bewegungsrichtung der Elektroden, welche durch einen Lageistwert eines die Elektroden öffnenden und schließenden Antriebs gegeben sein kann.

Der erste Wert beschreibt somit die Position bzw. Lage vor Beginn des Verflüssigens der Werkstückoberflächen und somit insbesondere vor bzw. zu Beginn des Schweißprozesses, zweckmäßigerweise relativ zu dem Schweißpunkt. Der zweite Wert beschreibt die Position/Lage nach Beginn des Verflüssigens der Werkstückoberflächen und somit insbesondere nach bzw. zum Ende des Schweißprozesses, ebenfalls insbesondere relativ zu dem Schweißpunkt. Ein Vergleich des ersten und zweiten Werts lässt insbesondere Rückschlüsse zu, wie sich die Position der Schweißelektroden relativ zu dem Schweißpunkt und somit ferner wie sich die Werkstücke an dem Schweißpunkt während des Schweißprozesses verändert haben. Somit ermöglicht dieser Vergleich aussagekräftige Rückschlüsse über die Qualität der an dem Schweißpunkt erzeugten Schweißverbindung der Werkstücke und somit über die Qualität des Schweißprozesses.

Der Lageistwert stellt einen besonders vorteilhaften Schweißelektrodenparameter dar, um auf Eigenschaften und Gegebenheiten des Schweißprozesses rückzuschließen und um insbesondere die Qualität des Schweißprozesses beurteilen zu können. Da sich bei Schweißspritzern flüssiges Metall von den Werkstücken entfernt, führt dies dazu, dass die Schweißelektroden weiter auf die Werkstücke zu bewegt werden und sich der Lageistwert insbesondere erhöht.

Insbesondere können Werte des Schweißelektrodenparameters auch zwischen dem ersten und dem zweiten Zeitpunkt, also insbesondere während des Schweißprozesses weiterhin bestimmt werden und für die Bewertung der Qualität verwendet werden. Somit kann der Schweißprozess mit Hilfe des Schweißelektrodenparameters insbesondere kontinuierlich überwacht werden.

Gemäß einer vorteilhaften Ausführungsform ist der erste Zeitpunkt ein Zeitpunkt, zu welchem die Schweißelektroden mit der Elektrodenkraft gegen den Schweißpunkt der Werkstücke gepresst werden, aber noch nicht mit dem Schweißstrom bestromt werden. Insbesondere findet der erste Zeitpunkt in diesem Fall vor einem Beginn des Schweißprozesses statt. Beispielsweise kann der erste Zeitpunkt in diesem Fall in der sog. Vorhaltephase liegen, welche beim Widerstandsschweißen zwischen der Kraftaufbauphase und dem Beginn des Schweißprozesses liegt.

Vorteilhafterweise ist der zweite Zeitpunkt ein Zeitpunkt, zu welchem die Schweißelektroden nicht mehr mit dem Schweißstrom bestromt werden, aber noch mit der Elektrodenkraft gegen den Schweißpunkt der Werkstücke gepresst werden. Somit findet der zweite Zeitpunkt insbesondere nach einem Ende des Schweißprozesses statt. In diesem Fall kann der zweite Zeitpunkt beispielsweise in der sog. Nachhaltephase liegen, insbesondere nach dem Ende des Schweißprozesses bevor die Schweißelektroden von dem Schweißpunkt weg bewegt werden.

Alternativ ist gemäß einer vorteilhaften Ausführungsform auch denkbar, dass zu dem ersten und/oder zweiten Zeitpunkt ein - insbesondere kein Verflüssigen der Oberflächen verursachender - Schweißstrom fließt.

Bevorzugt ist der erste Zeitpunkt ein Zeitpunkt während einer Stromaufbauphase, also während die Schweißstromstärke nach Beginn der Bestromung der Schweißelektroden ansteigt. Alternativ ist der erste Zeitpunkt bevorzugt ein Zeitpunkt während einer sog. Vorkonditionierungsphase, während welcher insbesondere bereits ein Schweißstrom durch die Schweißelektroden fließt, dessen Schweißstromstärke jedoch noch zu gering ist, so dass noch kein Verflüssigen der Werkstückoberflächen erfolgt. Alternativ ist der erste Zeitpunkt vorzugsweise ein Zeitpunkt innerhalb der ersten 10% der Dauer der Schweißzeit.

Bevorzugt ist der zweite Zeitpunkt ein Zeitpunkt während einer Stromabbauphase, also während die Schweißstromstärke auf den Wert Null verringert wird. Alternativ ist der zweite Zeitpunkt bevorzugt ein Zeitpunkt während einer sog. Nachwärmphase, während welcher noch ein Schweißstrom durch die Schweißelektroden fließt, wobei die Schweißstromstärke jedoch bereits zu gering ist, um die Werkstückoberflächen noch weiter zu verflüssigen. Alterativ ist der zweite Zeitpunkt ein Zeitpunkt innerhalb der letzten 10% der Dauer der Schweißzeit.

Gemäß einer besonders bevorzugten Ausführungsform werden aus dem ersten Wert und dem zweiten Wert Auswirkungen von Schweißspritzern auf die Qualität des Schweißprozesses quantifiziert. Als Schweißspritzer sind Tropfen geschmolzenen Metalls zu verstehen, welche aufgrund der extremen Intensität von Hitze und Kraft, die an oder um den Schweißpunkt herum aufgebracht werden, ausbrechen. Derartige Schweißspritzer können die Schweißqualität negativ beeinflussen, da das somit verlorene Material am Schweißpunkt nicht mehr zur Verfügung steht.

Da durch einen Schweißspritzer flüssiges Metall von den Werkstücken wegbewegt wird, werden die Schweißelektroden beim Auftreten eines Schweißspritzers weiter auf die Werkstücke bzw. aufeinander zu bewegt und die aktuelle Lage bzw. Position der Schweißelektroden verändert sich. Mit Hilfe des Schweißelektrodenparameters, welcher insbesondere die Lage bzw. Position der Schweißelektroden relativ zu dem Schweißpunkt charakterisiert, können die Auswirkungen von Schweißspritzer beurteilt und insbesondere quantifiziert werden.

Je mehr Material an dem Schweißpunkt durch Schweißspritzer verloren geht, desto negativer sind die Auswirkungen auf die Qualität des Schweißprozesses, desto weiter werden die Schweißelektroden im Zuge des Schweißprozesses an dem Schweißpunkt aufeinander zu bewegt, desto größer ist die Veränderung des Schweißelektrodenparameters und desto größer ist der Unterschied zwischen dem ersten und zweiten Wert des Schweißelektrodenparameters.

Auf herkömmliche Weise können Auswirkungen von Schweißspritzern auf die Qualität des Schweißpunktes bzw. des Schweißprozesses zumeist nicht ohne weiteres beurteilt werden, da diese von einer Vielzahl verschiedener Faktoren abhängen, beispielsweise von den Dicken der einzelnen Werkstücke oder davon, in welcher Ebene der Verbindung der Spritzer auftritt, etwa an der Oberfläche eines der Werkstücke oder zwischen den Werkstücken. Mit Hilfe des Schweißelektrodenparameters wird es nun ermöglicht, Auswirkungen von Schweißspritzern auf die Schweißprozessqualität beurteilen und quantifizieren zu können.

Vorteilhafterweise wird eine Differenz des ersten Werts und des zweiten Werts gebildet und diese Differenz mit wenigstens einem Schwellwert verglichen. Diese Differenz quantifiziert zweckmäßigerweise die Veränderung der Lage der Schweißelektroden relativ zu dem Schweißpunkt während des Schweißprozesses und ferner insbesondere die Veränderung der Werkstücke an dem Schweißpunkt. Somit stellt diese Differenz eine besonders vorteilhafte quantitative Größe dar, um die Qualität des Schweißprozesses beurteilen zu können.

Vorzugsweise werden als Qualität des Schweißprozesses eine Eindrucktiefe und/oder eine Restwandstärke des Schweißpunkts beurteilt. Als Eindrucktiefe sei insbesondere zu verstehen wie tief die Schweißelektroden im Zuge des Schweißprozesses an dem Schweißpunkt in die Werkstücke eindringen. Als Restwandstärke sei insbesondere die Dicke der an dem Schweißpunkt verbundenen Werkstücke zu verstehen. Insbesondere charakterisieren sowohl die Eindrucktiefe als auch die Restwandstärke die Veränderung der Werkstücke an dem Schweißpunkt und erlauben eine Aussage über die Qualität des Schweißprozesses. Insbesondere kann von dem Schweißelektrodenparameter, welcher die Lage der Schweißelektroden charakterisiert, auf die Eindrucktiefe rückgeschlossen werden. Von der Eindrucktiefe kann zweckmäßigerweise auf die Restwandstärke und von dieser wiederum insbesondere auf die Qualität des Schweißprozesses rückgeschlossen werden. Bevorzugt werden aus dem ersten Wert und dem zweiten Wert die Eindrucktiefe und/oder eine Restwandstärke des Schweißpunkts quantifiziert. Der die Lage der Schweißelektroden charakterisierende Schweißelektrodenparameter und insbesondere dessen erster Wert unmittelbar vor und dessen zweiter Wert unmittelbar nach dem Schweißprozess stellen somit eine besonders vorteilhafte Möglichkeit dar, um derartige quantitative Größen zum Beurteilen der Schweißprozessqualität zu bestimmen.

Vorteilhafterweise ist der Schweißelektrodenparameter ein Antriebsparameter des Elektrodenantriebs. Als Antriebsparameter seien in diesem Zusammenhang insbesondere Größen bzw. Parameter zu verstehen, welche im Zuge einer Regelung bzw. Steuerung des Elektrodenantriebs bestimmt werden, um die Schweißelektroden auf vorgegebene Weise zu bewegen und gegen die Werkstücke zu pressen. Insbesondere charakterisiert der Antriebsparameter die aktuelle Lage bzw. Position oder Bewegung der Schweißelektroden. Von den Werten des Antriebsparameters kann daher zweckmäßigerweise auf die aktuelle Lage der Schweißelektroden rückgeschlossen werden und davon ausgehend wiederum auf den Schweißprozess bzw. die Eigenschaften der Werkstücke. Daher bietet sich der Antriebsparameter besonders vorteilhaft für die Beurteilung der Qualität des Schweißprozesses an.

Beispielsweise kann der Antriebsparameter eine Steuer- und/oder Regelungsgröße des Elektrodenantriebs sein, insbesondere ein Istwert und/oder Sollwert des Elektrodenantriebs, welche im Zuge der Regelung des Elektrodenantriebs bestimmt werden, um die Elektrodenkraft auf einen vorgegebenen Wert zu regeln. Bei dem Elektrodenantrieb kann es sich insbesondere um einen elektrischen und/oder mechanischen und/oder pneumatischen Elektrodenantrieb handeln. Bei dem Antriebsparameter kann es sich daher beispielsweise um eine entsprechende elektrische und/oder mechanische und/oder pneumatische Größe handeln.

Vorzugsweise wird somit eine Möglichkeit bereitgestellt, Antriebsparameter, welche für die Regelung bzw. Steuerung des Elektrodenantriebs bestimmt werden, ferner für die Beurteilung der Qualität des Schweißprozesses zu verwenden. Auf herkömmliche Weise erfolgt beim Widerstandsschweißen zumeist eine Regelung des Elektrodenantriebs, meist mittels eines entsprechenden Antriebsregelgeräts, und davon unabhängig eine Regelung des Schweißprozesses, zumeist mittels einer separaten, unabhängigen Schweißsteuerung. Im Zuge der Schweißprozessregelung kann üblicherweise nicht auf Parameter der Antriebsregelung zugegriffen werden. Im Rahmen des vorliegenden Verfahrens hat es sich jedoch als besonders vorteilhaft herausgestellt, wenn Antriebsparameter der Regelung des Elektrodenantriebs für die Beurteilung der Qualität des Schweißprozesses einbezogen werden. Das vorliegende Verfahren stellt somit vorteilhafterweise eine Möglichkeit bereit, die Regelungen des Schweißprozesses und des Elektrodenantriebs miteinander zu verknüpfen und die zumeist ohnehin für die Regelung des Elektrodenantriebs bestimmten Antriebsparameter in die Regelung des Schweißprozesses zum Beurteilen der Schweißprozessqualität einzubinden.

Vorteilhafterweise wird im Zuge des Vergleichs ferner eine Blechdickenkombination der Werkstücke berücksichtigt. Als Blechdickenkombination (BDK) sei in diesem Zusammenhang eine Kombinationen aus miteinander zu verschweißenden Werkstücken mit unterschiedlichen Werkstückdicken zu verstehen, wobei als Werkstückdicke wiederum insbesondere eine Dicke des jeweiligen Werkstücks in einer Richtung senkrecht zu der Schweißrichtung bzw. in einer Richtung parallel zu einer Richtung, entlang welcher durch den Schweißprozess Kraft auf die Werkstücke ausgeübt wird, zu verstehen ist.

Zumeist ist der für eine spezielle Blechdickenkombination notwendige Schweißbereich sehr schmal, also der Bereich bei der eine gute Qualität des Schweißprozesses zu erreichen ist. Daraus ergibt sich die Gefahr beim Widerstandsschweißen einer speziellen Blechdickenkombination aus dem entsprechenden Schweißbereich herauszuwandern, wodurch die Zahl der Schweißspritzer zunimmt und die Qualität der Schweißverbindung abnimmt. Daher wird nun im Rahmen des Verfahrens vorteilhafterweise auch die Blechdickenkombination der zu verschweißenden Werkstücke zur Beurteilung der Qualität des Schweißprozesses berücksichtigt. So kann im Zuge der Qualitätsbeurteilung beispielsweise die nach dem Schweißprozess verbleibende Restwandstärke des Schweißpunkts mit den Dicken der Werkstücke verglichen werden und somit beurteilt werden, ob der Schweißpunkt zwar ausgebildet ist, aber nicht eine notwendige Festigkeit erreicht.

Das vorliegende Verfahren bietet sich daher besonders vorteilhafterweise für Prozesse an, bei welchem eine Vielzahl von Schweißpunkten mit komplexen, verschiedenen Blechdickenkombinationen miteinander zu verschweißen sind. Beispielsweise eignet sich das Verfahren besonders vorteilhaft für den Karosserierohbau, insbesondere für automatisierte Schweißprozesse im Karosserierohbau, vorzugsweise im Zuge einer Kraftfahrzeugproduktion. Insbesondere werden dabei Bleche miteinander verschweißt, um die Karosserie eines Kraftfahrzeugs herzustellen. Im Zuge des Herstellungsprozesses einer einzigen Karosserie können bis zu mehrere tausend Schweißpunkte mit mehreren hundert verschiedenen Blechdickenkombinationen automatisiert bearbeitet werden, z.B. ca. 5.000 Schweißpunkte mit ca. 700 verschiedenen Blechdickenkombinationen für ein Mittelklasse-Fahrzeug. Durch das Verfahren kann präzise die Qualität der einzelnen Schweißpunkte beurteilt werden.

Vorzugsweise wird im Zuge des Vergleichs ferner wenigstens ein Schweißparameter berücksichtigt. Unter Schweißparametern sind dabei in diesem Zusammenhang zweckmäßigerweise Größen bzw. Parameter zu verstehen, welche den Schweißprozesses selbst betreffen und somit insbesondere einen elektrischen Betrieb der Schweißelektroden. Insbesondere können der Schweißstrom und/oder eine Schweißspannung und/oder die Stromzeit bzw. Schweißzeit (d.h. die Zeit, während welcher der Schweißstrom fließt) als Schweißparameter berücksichtigt werden. Ebenso ist es denkbar, eine Reaktion der Schweißprozessregelung auf den wenigsten einen Schweißparameter zu berücksichtigen.

Bevorzugt sind die Werkstücke aus Aluminium und/oder Stahl. Die Werkstücke können dabei beispielsweise dünne Bleche mit einer Dicke von insbesondere bis zu 1 mm sein. Ein Widerstandsschweißen derartiger Werkstücke stellen besonders schwierige Anwendungsfälle für eine präzise Schweißprozessregelung dar. Durch das vorliegende Verfahren kann die Qualität des Schweißprozesses in derartigen schwierigen Anwendungsfällen präzise beurteilt werden.

Eine erfindungsgemäße Steuereinheit (Recheneinheit), z.B. eine Schweißsteuerung eines Schweißgeräts, ist, insbesondere programmtechnisch, dazu eingerichtet, ein erfindungsgemäßes Verfahren durchzuführen. Die Steuereinheit bzw. Schweißsteuerung kann beispielsweise als SPS (speicherprogrammierbare Steuerung), als NC (Numerical Control) oder CNC (Computerised Numerical Control) ausgebildet sein.

Ein erfindungsgemäßes Schweißgerät zum Widerstandsschweißen weist insbesondere eine Schweißzange mit Schweißelektroden sowie einen Elektrodenantrieb zum Bewegen der Schweißelektroden auf. Ferner umfasst das Schweißgerät eine bevorzugte Ausgestaltung einer erfindungsgemäßen Steuereinheit.

Auch die Implementierung eines erfindungsgemäßen Verfahrens in Form eines Computerprogramms mit Programmcode zur Durchführung aller Verfahrensschritte ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere magnetische, optische und elektrische Speicher, wie z.B. Festplatten, Flash-Speicher, EEPROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsbeispielen in der Zeichnung schematisch dargestellt und wird im Folgenden unter Bezugnahme auf die Zeichnung ausführlich beschrieben.

### Figurenbeschreibung

- Fig. 1: zeigt schematisch eine bevorzugte Ausgestaltung eines erfindungsgemäßen Schweißgeräts, das dazu eingerichtet ist, eine bevorzugte Ausführungsform eines erfindungsgemäßen Verfahrens durchzuführen.
- Fig. 2: zeigt schematisch eine bevorzugte Ausführungsform eines erfindungsgemäßen Verfahrens als ein Blockdiagramm.
- Fig. 3: zeigt schematisch zeitliche Verläufe von Schweißelektrodenparametern, die im Zuge einer bevorzugten Ausführungsform eines erfindungsgemäßen Verfahrens bestimmt werden können.
- Fig. 4: zeigt schematisch zeitliche Verläufe von Schweißelektrodenparametern, die im Zuge einer bevorzugten Ausführungsform eines erfindungsgemäßen Verfahrens bestimmt werden können.

### Detaillierte Beschreibung der Zeichnung

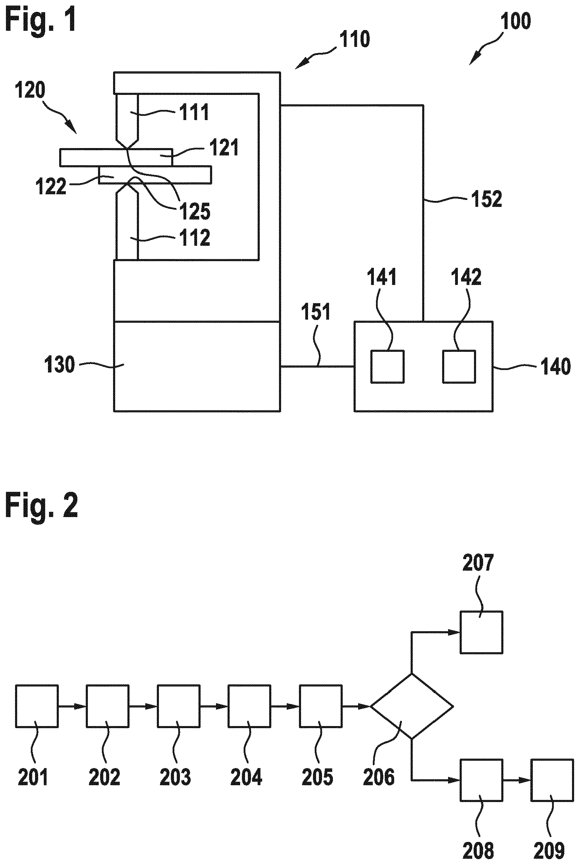

In Figur 1 ist ein Schweißgerät zum Widerstandsschweißen schematisch dargestellt und mit 100 bezeichnet.

Mit dem Schweißgerät 100 können Werkstücke 120 durch Widerstandsschweißen miteinander stoffschlüssig verbunden werden. Insbesondere werden die Werkstücke 120 im Zuge eines Karosserierohbaus miteinander verschweißt, wobei insbesondere eine Karosserie eines Kraftfahrzeugs hergestellt wird. Als Werkstücke werden hier beispielsweise zwei Bleche 121 und 122 aus Aluminium miteinander verschweißt.

Das Schweißgerät 100 weist eine Schweißzange 110 mit zwei Schweißelektroden 111 und 112 auf. Ein Elektrodenantrieb 130 ist vorgesehen, um die Schweißelektroden 111, 112 zu bewegen. In Figur 1 ist die Schweißzange 110 beispielsweise als eine servoelektrische Schweißzange dargestellt mit einem als Servomotor ausgebildeten Elektrodenantrieb 130. Ebenso ist es denkbar, dass der Elektrodenantrieb 130 beispielsweise als Elektromotor, Hydraulikmotor oder Pneumatikmotor ausgebildet sein kann.

Im Zuge des Widerstandsschweißens werden während einer sog. Kraftaufbauphase die Schweißelektroden 111 und 112 mit Hilfe des Elektrodenantriebs 130 mit einer Elektrodenkraft an einem Schweißpunkt 125 gegen die Bleche 121 und 122 gedrückt. Anschließend werden die Schweißelektroden 111 und 112 während des eigentlichen Schweißprozesses für die Dauer einer Schweißzeit mit einem Schweißstrom bestromt, wodurch eine Widerstandserwärmung der Bleche 121 und 122 am Schweißpunkt 125 erfolgt und es zu einem Verflüssigen der Oberfläche der Werkstücke 121, 122 kommt.

Ferner weist das Schweißgerät 100 eine Steuereinheit (Schweißsteuerung) 140 auf, welche beispielsweise als SPS (speicherprogrammierbare Steuerung) ausgebildet sein kann. Die Steuereinheit 140 ist dazu eingerichtet, den Elektrodenantrieb 130 zu regeln, angedeutet durch Bezugszeichen 151, und ferner den Schweißprozess, angedeutet durch Bezugszeichen 152. Zu diesem Zweck werden in der Steuereinheit 130 eine entsprechende Antriebsregelung 141 und eine entsprechende Schweißprozessregelung 142 durchgeführt, welche jeweils als entsprechende Steuerungsprogramme oder auch als ein gemeinsames Steuerungsprogramm implementiert sein können.

Die Steuereinheit 140 ist ferner dazu eingerichtet, eine Qualität des Schweißprozesses bzw. des erzeugten Schweißpunkts 125 zu beurteilen. Zu diesem Zweck ist die Steuereinheit 140, insbesondere programmtechnisch, dazu eingerichtet, eine bevorzugte Ausführungsform eines erfindungsgemäßen Verfahrens durchzuführen, welche in Figur 2 schematisch als ein Blockdiagramm dargestellt ist und nachfolgend in Bezug auf die Figuren 1 und 2 erläutert wird.

Schritt 201 bezeichnet die Kraftaufbauphase, im Zuge derer die Schweißelektroden 111 und 112 mit Hilfe des Elektrodenantriebs 130 an dem Schweißpunkt 125 gegen die Bleche 121 und 122 gedrückt werden, bis die vorgegebene Elektrodenkraft erreicht ist.

Schritt 202 bezeichnet eine sog. Vorhaltephase, während welcher die Schweißelektroden 111, 112 mit der Elektrodenkraft vor Beginn des Schweißprozesses gegen den Schweißpunkt 125 der Werkstücke 121, 122 gepresst werden, aber noch nicht mit dem Schweißstrom bestromt werden. Während dieser Vorhaltephase wird im vorliegenden Beispiel zu einem ersten Zeitpunkt vor einem Beginn des Verflüssigens der Oberflächen der Werkstücke 121, 122 ein erster Wert eines Lageistwert des Elektrodenantriebs 130, welcher die aktuelle Lage der Schweißelektroden 111, 112 charakterisiert, als Schweißelektrodenparameters bestimmt.

In Schritt 203 erfolgt nun der Schweißprozess, im Zuge dessen die Schweißelektroden 111, 112 für die Dauer der Schweißzeit mit dem Schweißstrom bestromt werden.

Es ist auch denkbar, den ersten Wert des Lageistwerts nach Beginn des Schweißprozesses während der ersten Phasen zu bestimmen, solange noch kein Verflüssigen der Werkstückoberflächen erfolgt. Beispielsweise kann der erste Wert dann zu einem ersten Zeitpunkt bestimmt werden, der innerhalb von bis zu 10% Prozent der Schweißdauer liegen kann, z.B. während einer sog. Vorkonditionierungsphase.

Nach dem Ende der Schweißzeit und nachdem die Bestromung der Schweißelektroden 111, 112 beendet wurde, erfolgt in Schritt 204 die sog. Nachhaltephase, während welcher die Schweißelektroden 111, 112 noch mit der Elektrodenkraft gegen den Schweißpunkt 125 der Werkstücke 121, 122 gepresst, aber nicht mehr mit dem Schweißstrom bestromt werden. Während dieser Nachhaltephase wird im vorliegenden Beispiel zu einem zweiten Zeitpunkt nach Beginn des Verflüssigens der Oberflächen der Werkstücke 121, 122 ein zweiter Wert des Schweißelektrodenparameters bestimmt, also des Lageistwerts des Elektrodenantriebs 130. Insbesondere liegt der zweite Zeitpunkt hier bereits nach dem Ende des Verfestigens.

Alternativ kann der zweite Wert des Lageistwerts auch während der letzten Phasen vor Ende des Schweißprozesses bestimmt werden, wenn noch ein geringer Schweißstrom fließt. Beispielsweise kann der zweite Wert zu einem zweiten Zeitpunkt bestimmt werden, der ab 90% der vollständigen Schweißdauer liegen kann, etwa während einer sog. Nachwärmphase.

Der erste Wert und der zweite Wert des Lageistwerts werden nun miteinander verglichen und in Abhängigkeit von einem Vergleichsergebnis wird eine Qualität des Schweißprozesses bzw. des erzeugten Schweißpunkts 125 beurteilt. Zu diesem Zweck wird in Schritt 205 eine Differenz des ersten Werts und des zweiten Werts gebildet. Diese Differenz charakterisiert insbesondere, wie sich der Lageistwert während des Schweißprozesses verändert hat. Wenn während des Schweißprozesses Schweißspritzer auftreten, wird flüssiges Metall am Schweißpunkt 125 von den Werkstücken 121, 122 entfernt, die Schweißelektroden 111, 112 bewegen sich weiter aufeinander zu und der Lageistwert erhöht sich. Somit stellt diese Differenz eine besonders vorteilhafte Größe dar, um die Auswirkungen von Schweißspritzern auf die Qualität des Schweißprozesses beurteilen und quantifizieren zu können.

In Schritt 206 wird die Differenz nun mit einem Schwellwert verglichen. Der Schwellwert kann beispielsweise abhängig von einer Blechdickenkombination der zu verschweißenden Werkstücke 121, 122 gewählt werden. Wenn die Differenz den Schwellwert nicht erreicht, deutet dies darauf hin, dass sich die Lage der Schweißelektroden 111, 112 während des Schweißprozesses nicht um mehr als einen zulässigen Wert verändert hat und dass somit kein Schweißspritzer aufgetreten ist oder dass beim Auftreten eines Schweißspritzers zumindest keine Qualitätsbeeinträchtigung aufgetreten ist. In Schritt 207 wird in diesem Fall beurteilt, dass eine hohe Qualität des Schweißprozesses bzw. des Schweißpunkts 125 erreicht wurde.

Wenn die Differenz den Schwellwert hingegen erreicht oder überschreitet, hat sich die Lage der Schweißelektroden 111, 112 während des Schweißprozesses um mehr als den zulässigen Wert verändert, da ein Schweißspritzer aufgetreten ist. In Schritt 208 wird in diesem Fall beurteilt, dass die Restwandstärke des Schweißpunkts 125 nicht ausreichend hoch ist, um eine gewünschte Festigkeit zu gewähren und dass keine ausreichende Qualität des Schweißprozesses bzw. des Schweißpunkts 125 erreicht wurde. In diesem Fall kann in Schritt 209 eine entsprechende Maßnahme durchgeführt werden, beispielsweise kann eine Fehlermeldung ausgegeben werden, dass der Schweißpunkt 125 zwar ausgebildet ist, aber nicht die nötige Festigkeit erreicht hat.

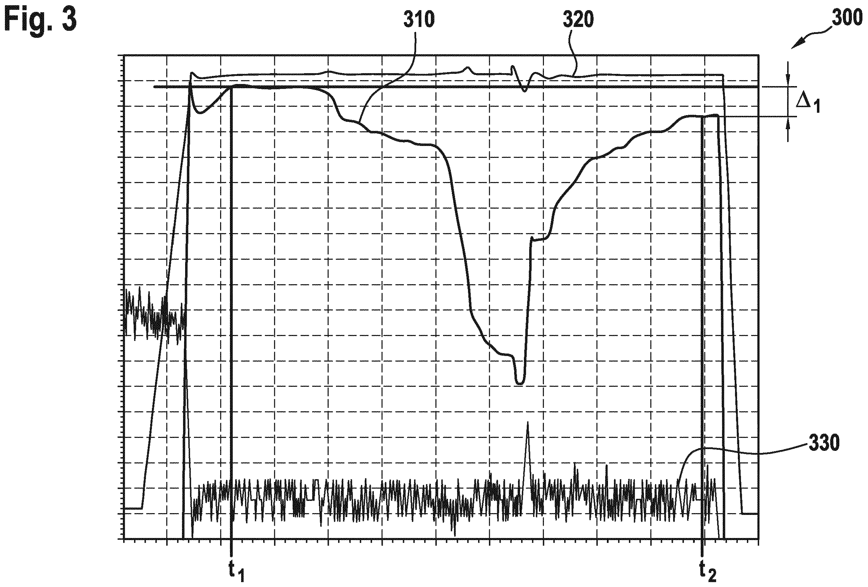

Figur 3 zeigt schematisch ein Diagramm 300 von Schweißelektrodenparametern aufgetragen gegen die Zeit, die im Zuge einer bevorzugten Ausführungsform des erfindungsgemäßen Verfahrens bestimmt werden können.

Kurve 310 zeigt den zeitlichen Verlauf des Lageistwerts. Ferner sind in Figur 3 der zeitliche Verlauf 320 der Elektrodenkraft sowie der zeitliche Verlauf 330 des Drehzahlistwerts des Elektrodenantriebs 130 dargestellt. Die in Figur 3 dargestellten Kurven 310, 320, 330 charakterisieren insbesondere einen Schweißprozess mit hoher Qualität, bei welchem kein Schweißspritzer aufgetreten ist.

In Figur 3 ist ferner die Differenz Δ₁ des zu dem ersten Zeitpunkt t₁ bestimmten ersten Werts des Lageistwerts und des zu dem zweiten Zeitpunkt t₂ bestimmten zweiten Werts des Lageistwerts dargestellt. Die Differenz Δ₁ besitzt im gezeigten Bespiel einen positiven Wert, was darauf hindeutet, dass sich die Elektroden auseinander bewegt haben und somit kein Schweißspritzer aufgetreten ist.

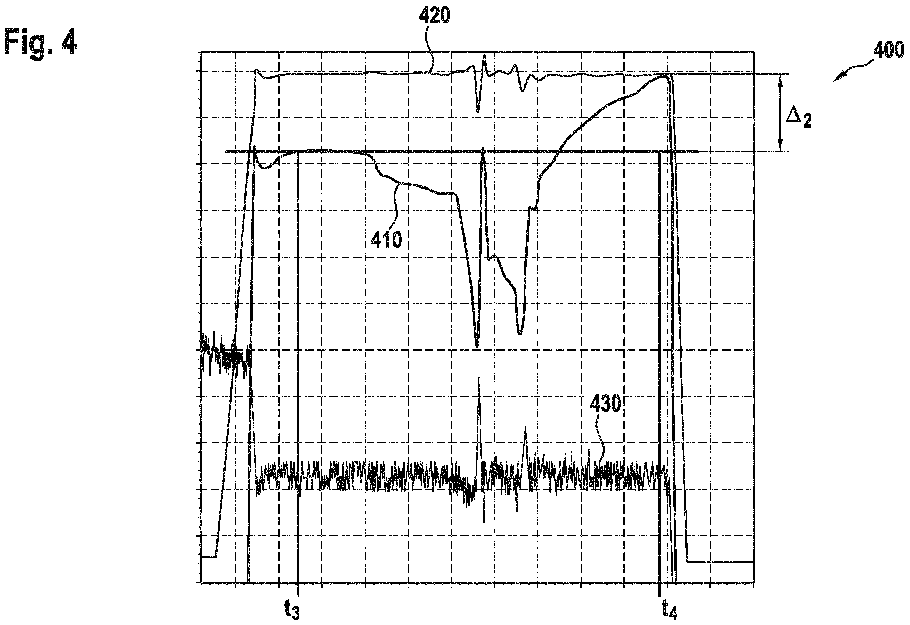

Analog zu Figur 3 zeigt auch Figur 4 schematisch ein Diagramm 400 von Schweißelektrodenparametern aufgetragen gegen die Zeit, die im Zuge einer bevorzugten Ausführungsform des erfindungsgemäßen Verfahrens bestimmt werden können. Auch in Figur 4 sind die zeitlichen Verläufe des Lageistwerts 410, der Elektrodenkraft 420 sowie des Drehzahlistwerts 430 des Elektrodenantriebs 130 dargestellt. Figur 4 zeigt jedoch den Fall eines Schweißprozesses mit nicht ausreichender Qualität, bei welchem ein Schweißspritzer aufgetreten ist.

Figur 4 zeigt ferner analog zu Figur 3 die Differenz Δ₂ des zu dem ersten Zeitpunkt t₃ bestimmten ersten Werts des Lageistwerts und des zu dem zweiten Zeitpunkt t₄ bestimmten zweiten Werts des Lageistwerts. Die Differenz Δ₁ besitzt in diesem Bespiel einen negativen Wert, was auf ein Aufeinanderzubewegen der Elektroden und somit auf einen Schweißspritzer hindeutet.

## Patentansprüche

1. Verfahren zum Überprüfen der Qualität bei einem Widerstandsschweißen von Werkstücken (121, 122), wobei Schweißelektroden (111, 112) mit Hilfe eines Elektrodenantriebs (130) mit einer Elektrodenkraft gegen einen Schweißpunkt (125) der Werkstücke (121, 122) gepresst werden (201) und wobei im Zuge eines Schweißprozesses die Schweißelektroden (111, 112) für die Dauer einer Schweißzeit mit einem Schweißstrom bestromt werden (203), um eine Oberfläche der Werkstücke (121, 122) zu verflüssigen,
**dadurch gekennzeichnet, dass**
zu einem ersten Zeitpunkt (t₁, t₃) vor einem Beginn des Verflüssigens ein erster Wert eines eine Lage einer oder beider Elektroden kennzeichnenden Schweißelektrodenparameters (310, 410) bestimmt wird (202), wobei zu dem ersten Zeitpunkt (t₁, t₃) die Schweißelektroden (111, 112) mit der Elektrodenkraft gegen den Schweißpunkt (125) der Werkstücke (121, 122) gepresst werden (202),
zu einem zweiten Zeitpunkt (t₂, t₄) nach einem Beginn des Verflüssigens ein zweiter Wert des eine Lage einer oder beider Elektroden kennzeichnenden Schweißelektrodenparameters (310, 410) bestimmt wird (204), wobei zu dem zweiten Zeitpunkt (t₂, t₄) die Schweißelektroden (111, 112) mit der Elektrodenkraft gegen den Schweißpunkt (125) der Werkstücke (121, 122) gepresst werden (204),
der erste Wert und der zweite Wert miteinander verglichen werden und in Abhängigkeit von einem Vergleichsergebnis eine Qualität des Schweißprozesses beurteilt wird (205, 206).

2. Verfahren nach Anspruch 1, wobei aus dem ersten Wert und dem zweiten Wert Auswirkungen von Schweißspritzer auf die Qualität des Schweißprozesses quantifiziert werden (205, 206).

3. Verfahren nach Anspruch 1 oder 2, eine Differenz (Δ₁, Δ₂) des ersten Werts und des zweiten Werts gebildet wird (205) und wobei diese Differenz (Δ₁, Δ₂) mit wenigstens einem Schwellwert verglichen wird (206).

4. Verfahren nach einem der vorstehenden Ansprüche, wobei als Qualität des Schweißprozesses eine Eindrucktiefe und/oder eine Restwandstärke des Schweißpunkts beurteilt werden (205, 206), wobei ferner insbesondere aus dem ersten Wert und dem zweiten Wert die Eindrucktiefe und/oder eine Restwandstärke des Schweißpunkts quantifiziert werden (205, 206).

5. Verfahren nach einem der vorstehenden Ansprüche, wobei der Schweißelektrodenparameter (310, 410) als Antriebsparameter des Elektrodenantriebs (130) erhalten wird und/oder ein Lageistwert (310, 410) der Schweißelektroden (111, 112) ist.

6. Verfahren nach einem der vorstehenden Ansprüche, wobei im Zuge des Vergleichs ferner eine Blechdickenkombination der Werkstücke (121, 122) und/oder wenigstens ein Schweißparameter berücksichtigt werden (206).

7. Verfahren nach einem der vorstehenden Ansprüche, wobei die Werkstücke (121, 122) aus Aluminium und/oder Stahl gefertigt sind.

8. Verfahren nach einem der vorstehenden Ansprüche, wobei der erste Zeitpunkt (t₁, t₃) ein Zeitpunkt ist, zu welchem die Schweißelektroden (111, 112) mit der Elektrodenkraft gegen den Schweißpunkt (125) der Werkstücke (121, 122) gepresst werden, aber noch nicht mit dem Schweißstrom bestromt werden.

9. Verfahren nach einem der Ansprüche 1 bis 7, wobei der erste Zeitpunkt (t₁, t₃) ein Zeitpunkt während einer Stromaufbauphase, ein Zeitpunkt während einer Vorkonditionierungsphase oder ein Zeitpunkt innerhalb der ersten 10% der Dauer der Schweißzeit ist.

10. Verfahren nach einem der vorstehenden Ansprüche, wobei der zweite Zeitpunkt (t₂, t₄) ein Zeitpunkt ist, zu welchem die Schweißelektroden (111, 112) nicht mehr mit dem Schweißstrom bestromt werden, aber noch mit der Elektrodenkraft gegen den Schweißpunkt (125) der Werkstücke (121, 122) gepresst werden (204).

11. Verfahren nach einem der Ansprüche 1 bis 9, wobei der zweite Zeitpunkt (t₂, t₄) ein Zeitpunkt während einer Stromabbauphase, ein Zeitpunkt während einer Nachwärmphase oder ein Zeitpunkt innerhalb der letzten 10% der Dauer der Schweißzeit ist.

12. Steuereinheit (140), die dazu eingerichtet ist, ein Verfahren nach einem der vorstehenden Ansprüche durchzuführen.

13. Schweißgerät (100) mit einer Steuereinheit (140) nach Anspruch 12.

14. Computerprogramm, das eine Steuereinheit (140) veranlasst, ein Verfahren nach einem der Ansprüche 1 bis 11 durchzuführen, wenn es auf der Steuereinheit (140) ausgeführt wird.

15. Maschinenlesbares Speichermedium mit einem darauf gespeicherten Computerprogramm nach Anspruch 14.
